Europäisches Patentamt

European Patent Office

Office européen des brevets

(11) Veröffentlichungsnummer: **0 289 654**
**A2**

## EUROPÄISCHE PATENTANMELDUNG

(21) Anmeldenummer: 87116228.5

(22) Anmeldetag: 04.11.87

(51) Int. Cl.⁴: **H05K 3/34**

(30) Priorität: 02.05.87 DE 3714694

(43) Veröffentlichungstag der Anmeldung:
**09.11.88 Patentblatt 88/45**

(84) Benannte Vertragsstaaten:
**DE FR GB IT SE**

(71) Anmelder: **VDO Adolf Schindling AG**
**Gräfstrasse 103**
**D-6000 Frankfurt/Main(DE)**

(72) Erfinder: **Treffer, Frank**
**Rubensallee 93**
**D-6500 Mainz 31(DE)**

(74) Vertreter: **Klein, Thomas, Dipl.-Ing. (FH)**
**Sodener Strasse 9 Postfach 6140**
**D-6231 Schwalbach a. Ts.(DE)**

(54) Verfahren zum Verlöten der Anschlüsse eines elektronischen Bauteils sowie Folie zur Durchführung des Verfahrens.

(57) Eine Folie (15) hat Ausnehmungen (17), welche von Lötstreifen (18, 19) überbrückt sind. Die Ausnehmungen (17) sind so bemessen, daß sich die Lötstreifen (18, 19) quer über die Enden von Leiterbahnen (9 - 14) legen lassen. Danach wird das jeweilige elektronische Bauteil (2) mit seinen Anschlüssen (3 - 8) auf die Lötstreifen (18, 19) aufgesetzt. Mittels eines Stempels wird Druck ausgeübt und Wärme aufgebracht, was zum Schmelzen der Lötstreifen (18, 19) und damit zum Verlöten der Anschlüsse (3 - 8) mit den Leiterbahnen (9 - 14) führt.

Fig. 1

## Verfahren zum Verlöten der Anschlüsse eines elektronischen Bauteils sowie Folie zur Durchführung des Verfahrens

Die Erfindung bezieht sich auf ein Verfahren zum Verlöten der Anschlüsse eines elektronischen Bauteils mit Leiterbahnen eines Trägers durch Auflegen eines mehrere Anschlüsse überbrückenden Lötstreifens aus Lötmaterial und anschließender Wärmezufuhr zwecks Schmelzen des Lötstreifens. Weiterhin betrifft die Erfindung eine Folie zur Durchführung dieses Verfahrens.

Elektronische Bauteile lötet man bislang meist mittels einer sogenannten Lötwelle auf die Leiterbahnen eines Trägers auf. Das führt zwangsläufig zu unterschiedlichen Schichtdicken bei den in Längsrichtung und Querrichtung verlaufenden Leiterbahnen.

. Auch kommt es bei großen Schichtdicken zu starken Spannungen zwischen der mit Lot beschichteten Leiterbahn und dem die Leiterbahn aufweisenden Träger, was zu einem Lösen der Leiterbahnen führen kann.

Bei Flüssigkristallanzeigen ist es auch schon bekannt, über die Leiterbahnen eine Folie zu legen, welche auf der den Leiterbahnen abgewandten Seite Lötstreifen trägt, welche die von elektrischen Anschlüssen elektronischer Bauteile zu kontaktierenden Leiterbahnen überbrücken. Überall dort, wo ein elektrischer Anschluß mit einer Leiterbahn verlötet werden soll, ist in der Folie eine kleine Ausnehmung in Form eines Fensters vorgesehen. Nach dem Auflegen der Folie setzt man die elektronischen Bauteile auf die Folie und führt dann mittels eines auf die Anschlüsse drückenden Stempels Wärme zu. Nachteilig bei diesem Lötverfahren ist es, daß die einzelnen Ausnehmungen maßlich sehr genau mit der Lage der Leiterbahnen übereinstimmen müssen. Insbesondere, wenn mehrere Bauteile hintereinander auf einen Träger zu löten sind und hierzu Folie mit Lötstreifen von einer Rolle verwendet werden soll, kommt es durch Addition von Toleranzen zu so starken Abweichungen zwischen den Ausnehmungen und den Leiterbahnen, daß ein ordnungsgemäßes Verlöten nicht mehr gewährleistet ist.

Der Erfindung liegt die Aufgabe zugrunde, ein Verfahren der eingangs genannten Art zu entwickeln, mit dem ohne Toleranzprobleme auch eine Vielzahl von hintereinander anzuordnenden, elektronischen Bauteilen auf Leiterbahnen eines Trägers gelötet werden können. Weiterhin soll eine Folie zur Durchführung dieses Lötverfahrens entwickelt werden.

Die erstgenannte Aufgabe wird erfindungsgemäß dadurch gelöst, daß der Lötstreifen unmittelbar auf den Träger über mehrere von den Anschlüssen zu kontaktierende Leiterbahnen gelegt, darauf das elektronische Bauteil mit seinen Anschlüssen gesetzt und anschließend Wärme zwecks Schmelzen des Lötstreifens zugeführt wird.

Bei dieser Verfahrensweise werden die Leiterbahnen zunächst durch die Lötstreifen miteinander verbunden und damit kurzgeschlossen. Überraschenderweise zieht das Lötmaterial sich beim Schmelzen jedoch von dem Träger weg auf die Anschlüsse und Leiterbahnen, so daß die Leiterbahnen nach dem Löten nicht elektrisch miteinander verbunden sind. Durch Abstimmung der Dicke und Breite des Lötstreifens auf die Breite der Leiterbahnen kann man dafür sorgen, daß genau festgelegte Lötmengen auf die Leiterbahnen gelangen und damit im Gegensatz zu einem Löten mit einer Lötwelle exakte Lötmittelschichtdicken entstehen.

Das erforderliche, genaue Positionieren der Lötstreifen über die Leiterbahnen ist sehr leicht durchzuführen, wenn gemäß einer vorteilhaften Ausgestaltung der Erfindung zumindest ein Lötstreifen zunächst über eine Ausnehmung einer Folie gelegt und dort befestigt und anschließend diese Folie auf den Träger über die Leiterbahnen ausgerichtet wird.

Lötschichten für mehrere, elektronische Bauteile können mit geringem Arbeitsaufwand auf einmal aufgebracht werden, wenn eine Folie mit mehreren Ausnehmungen benutzt wird, welche jeweils durch zumindest einen Lötstreifen überbrückt sind.

Die zweitgenannte Aufgabe, nämlich die Schaffung einer Folie mit Lötstreifen zum Verlöten der Anschlüsse elektronischer Bauteile auf Leiterbahnen eines Trägers, welche von Lötstreifen überbrückte Ausnehmungen hat, wird erfindungsgemäß dadurch gelöst, daß die Ausnehmungen mehrere Leiterbahnen überdecken.

Eine solche Folie hat gegenüber der bekannten Folie mit Ausnehmungen für jede Leiterbahn den Vorteil, daß sie weniger toleranzanfällig ist. Das ist bei solchen Folien sehr wichtig, weil diese sich beispielsweise durch Temperatureinfluß leicht in ihrer Länge verändern.

Für elektronische Bauteile, welche an zwei gegenüberliegenden Seiten elektrische Anschlüsse haben, ist es vorteilhaft, wenn die Ausnehmungen an zwei gegenüberliegenden Seiten von den Lötstreifen überbrückt sind. Dadurch können mit der Folie mit einem Arbeitsgang jeweils die beiden erforderlichen Lötstreifen aufgebracht werden.

Eine solche Folie kann sehr schmal ausgebildet sein, wenn die Ausnehmungen nach einer Seite hin offene, rechteckige Folienausschnitte sind.

Möglich ist es jedoch auch, daß die Ausnehmungen allseitig von Folienmaterial umgebende Fenster sind.

Fensterförmige Ausnehmungen sind vor allem dann vorteilhaft, wenn elektronische Bauteile mit an vier Seiten vorgesehenen Anschlüssen auf Leiterbahnen aufgelötet werden sollen, weil dann jede fensterförmige Ausnehmung an ihren vier Kanten von jeweils einem Lötstreifen überbrückt sein kann, so daß alle vier erforderlichen Lötstreifen in einem Arbeitsgang mit der Folie aufgebracht und positioniert werden können.

Die Erfindung kann sehr unterschiedlich ausgeführt werden. Zu ihrer weiteren Verdeutlichung wird nachfolgend auf die Zeichnung Bezug genommen. Diese zeigt in

Fig. 1 eine Draufsicht auf einen für das erfindungsgemäße Verfahren wesentlichen Bereich einer Flüssigkristallzelle mit einer aufgelegten, Lötstreifen haltenden Folie,

Fig. 2 eine Draufsicht auf einen Teilbereich einer gegenüber der Figur 1 abgewandelten Ausführungsform der Folie.

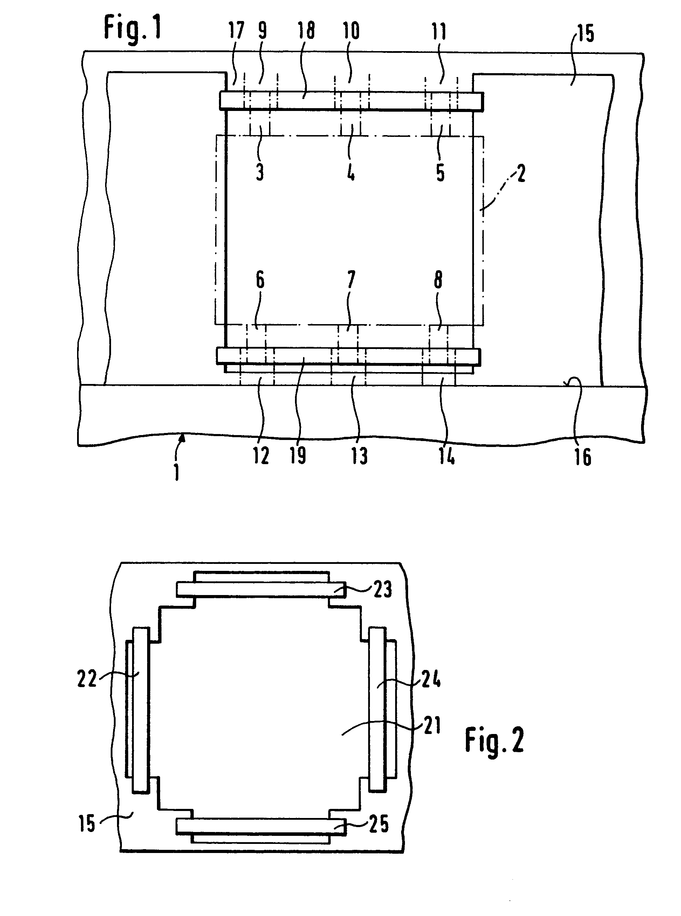

Die Figur 1 zeigt von einer Flüssigkristallzelle 1 einen solchen Bereich, auf den ein strichpunktiert dargestelltes, elektronisches Bauteil 2 mit seinen Anschlüssen 3, 4, 5, 6, 7, 8 auf die Enden von Leiterbahnen 9 - 14 aufgelötet werden muß. Vor dem Löten des elektronischen Bauteils 2 wird zunächst Flußmittel auf den Lötbereich der Flüssigkristallzelle 1 gegeben und dann eine Folie 15 auf die Flüssigkristallzelle 1 derart aufgelegt, daß diese gegen eine Kante 16 der Flüssigkristallzelle 1 anliegt und dadurch in eine Richtung positioniert ist. Die Folie 15 weist eine einseitig offene, rechteckige Ausnehmung 17 auf, die nahe der beiden Ränder der Folie 15 von jeweils einem Lötstreifen 18, 19 überbrückt ist. Diese Lötstreifen 18, 19 sind auf der der Flüssigkristallzelle 1 zugewandten Seite der Folie 15 auf ihr befestigt und liegen auf den Leiterbahnen 9 - 14 auf.

Hat man die Folie 15 auch in Längsrichtung richtig ausgerichtet, so setzt man das elektronische Bauteil 2 auf die Lötstreifen 18, 19 über die Leiterbahnen 9 - 14. Danach wird ein nicht gezeigter Stempel auf die Anschlüsse 3 - 8 gesetzt und unter Druck Wärme zugeführt. Diese führt zu einem Schmelzen der Lötstreifen 18, 19 und dadurch zu einem Verlöten der Anschlüsse 3 - 8 mit den Leiterbahnen 9 - 14. Erstaunlicherweise zieht sich das Lötmaterial beim Schmelzen der Lötstreifen 18, 19 auf die Leiterbahnen 9 - 14 zurück, so daß diese nicht durch das Lötmaterial miteinander verbunden und dadurch kurzgeschlossen werden. Nach dem Verlöten ist lediglich noch die Folie 15 von der Flüssigkristallzelle abzuziehen.

Die Figur 2 zeigt, daß die Folie 15 auch Ausnehmungen 21 haben kann, die fensterförmig ausgebildet sind und an ihren vier Kanten jeweils eine Ausbuchtung aufweisen, welche jeweils von einem Lötstreifen 22, 23, 24, 25 überbrückt ist. Mittels einer solchen Folie 15 ist es möglich, elektronische Bauteile, welche nach vier Seiten hin elektrische Anschlüsse aufweisen, nach dem erfindungsgemäßen Verfahren in einem Arbeitsgang mit Leiterbahnen zu verlöten.

Bei den elektronischen Bauteilen handelt es sich bei Flüssigkristallzellen um IC'S. Jede Flüssigkristallzelle 1 hat mehrere solcher IC'S hintereinander. Deshalb wird eine Folie verwendet, die ebenfalls hintereinander im Abstand der Anordnungsstellen für die IC'S die Ausnehmungen 17 bzw. 21 hat, so daß die Lötstreifen 18, 19; 22 - 25 aller IC's gleichzeitig aufgelegt werden können.

## Ansprüche

1. Verfahren zum Verlöten der Anschlüsse eines elektronischen Bauteils mit Leiterbahnen eines Trägers durch Auflegen eines mehrere Anschlüsse überbrückenden Lötstreifens aus Lötmaterial und anschließender Wärmezufuhr zwecks Schmelzen des Lötstreifens, dadurch gekennzeichnet, daß der Lötstreifen unmittelbar auf den Träger über mehrere von den Anschlüssen zu kontaktierende Leiterbahnen gelegt, darauf das elektronische Bauteil mit seinen Anschlüssen gesetzt und anschließend Wärme zwecks Schmelzen des Lötstreifens zugeführt wird.

2. Verfahren nach Anspruch 1, dadurch gekennzeichnet, daß zumindest ein Lötstreifen zunächst über eine Ausnehmung einer Folie gelegt und dort befestigt und anschließend diese Folie auf den Träger über die Leiterbahnen ausgerichtet wird.

3. Verfahren nach Anspruch 2, dadurch gekennzeichnet, daß zum Verlöten mehrerer, elektronischer Bauteile auf Leiterbahnen eines Trägers eine Folie mit mehreren Ausnehmungen benutzt wird, welche jeweils durch zumindest einen Lötstreifen überbrückt sind.

4. Folie mit Lötstreifen zum Verlöten der Anschlüsse elektronischer Bauteile auf Leiterbahnen eines Trägers, welche von Lötstreifen überbrückte Ausnehmungen hat, dadurch gekennzeichnet, daß die Ausnehmungen (17, 21) mehrere Leiterbahnen (9 - 14) überdecken.

5. Folie nach Anspruch 4, dadurch gekennzeichnet, daß die Ausnehmungen (17) an zwei gegenüberliegenden Seiten von den Lötstreifen (18, 19) überbrückt sind.

6. Folie nach Anspruch 4, dadurch gekennzeichnet, daß die Ausnehmungen (17) nach einer Seite hin offene, rechteckige Folienausschnitte sind.

7. Folie nach Anspruch 4, dadurch gekennzeichnet,daß die Ausnehmungen (21) allseitig von Folienmaterial umgebende Fenster sind.

8. Folie nach Anspruch 7, dadurch gekennzeichnet, daß jede fensterförmige Ausnehmung (21) an ihren vier Kanten von jeweils einem Lötstreifen (22 - 25) überbrückt ist.

# Fig.1

# Fig.2